# EUROPÄISCHE PATENTSCHRIFT

(11) **EP 3 694 299 B1**
(45) Veröffentlichungstag und Bekanntmachung des Hinweises auf die Patenterteilung: **12.07.2023**
(21) Anmeldenummer: 19156144.8
(22) Anmeldetag: 08.02.2019
(51) Int. Cl.: H05K 3/24, H05K 3/34, H05K 3/12, H05K 1/09

(54) **VERFAHREN ZUM HERSTELLEN EINER LÖTVERBINDUNG**
METHOD FOR PRODUCING A SOLDER CONNECTION
PROCÉDÉ DE FABRICATION D'UNE LIAISON PAR BRASAGE

(43) Veröffentlichungstag der Anmeldung: 12.08.2020
(73) Patentinhaber: FM Siebdruck Werbung Design GmbH, 71111 Waldenbuch (DE)
(72) Erfinder: Bayer, Michael, 73765 Neuhausen (DE)
(74) Vertreter: FARAGO Patentanwälte GmbH

(56) Entgegenhaltungen:
- DE-A1-102010 042 702
- DE-A1-102013 218 423
- US-A- 4 404 237

## Beschreibung

Die nachfolgend beschriebene Erfindung betrifft ein Verfahren zum Herstellen einer Lötverbindung nach dem Oberbegriff des Anspruchs 1.

Verfahren zum Herstellen von Lötverbindungen sind aus zahlreichen Druckschriften bekannt. So ist beispielsweise in der DE 10 2013 218 423 A1 beschrieben, auf einen Träger, insbesondere eine Leiterplatte, ein elektronisches Bauelement aufzubringen. Hierzu werden eine erste Schicht und eine zweite Schicht auf den Träger aufgebracht, wobei die erste Schicht Metallpartikel und ein Flussmittel und die zweite Schicht ein Lotmittel enthält. Die Metallpartikel soll eine Leiterschicht auf dem Träger bilden. Diese soll mit Hilfe des Lotmittels mit dem Bauelement verbunden werden. Zu diesem Zweck wird das Bauelement nach dem Aufbringen der beiden Schichten in Wirkverbindung mit den beiden Schichten gebracht. Der so gebildete Bauteileverbund wird einer Wärmebehandlung unterzogen, bei der die Metallpartikel in der ersten Schicht versintern und das Lotmittel verflüssigt wird. Das verflüssigte Lotmittel diffundiert aus der zweiten Schicht in bei der Versinterung entstehende Hohlräume in der ersten Schicht ein. Durch das Flussmittel werden dabei Oberflächen der Metallpartikel der ersten Schicht von Oxiden befreit, was die Infiltration des flüssigen Lots in die Gerüststruktur der gesinterten Metallpartikel unterstützt. Das Flussmittel beeinflusst allerdings die Druckbarkeit der ersten Schicht negativ. Darüber hinaus erfordert die Versinterung in Abhängigkeit der gewählten Metallpartikel hohe Temperaturen, was wiederum die Wahl des Trägers hinsichtlich seiner Temperaturbeständigkeit stark beschränkt.

Aus der DE 10 2008 031 004 A1 ist es bekannt, ein Lotpulver unter Verwendung eines festen Metallstearats auszubilden. Das Metallstearat ist in einem Bindemittel enthalten, das einen Lotwerkstoff umgibt. Es ist aus einem unedlen Metall wie Aluminium oder Mangan gebildet. Ein derartiges Metallstearat ist grundsätzlich dazu geeignet, Oxidschichten an den Oberflächen von Metallpartikeln zu reduzieren und dadurch ein Flussmittel überflüssig zu machen.

Aus der DE 10 2016 226 089 A1 ist ein Verfahren zum Herstellen einer Lötverbindung bekannt, bei dem eine erste und eine zweite Schicht auf einen Träger aufgebracht werden, wobei die erste Schicht neben Metallpartikeln mindestens ein Metallstearat und die zweite Schicht ein Lotmittel enthält. Auch hier sollen die Metallpartikel der ersten Schicht eine Leiterschicht auf dem Träger bilden. Der Träger und die beiden Schichten werden anschließend einer Wärmebehandlung unterzogen, bei der die zweite Schicht mit dem Lotmittel verflüssigt wird und in die Struktur der die Metallpartikel enthaltenden ersten Schicht eindringt. Das Metallstearat dient hier als Ersatz für in gängigen Flussmitteln enthaltenes Thixotropiermittel. Bevorzugt ist das Metallstearat aus Aluminium, also aus einem unedlen Metall, gebildet.

Aus der US 4404237 A ist es bekannt. zur Herstellung von Leiterbahnen Partikel aus einem vergleichsweise unedlen Material mit einem Überzug aus einem vergleichsweise edlen Material zu überziehen. Hierzu wird die Leiterbahn mit einer Metallsalzlösung in Kontakt gebracht, aus der das vergleichsweise edle Metall abgeschieden wird.

Aus der DE 10 2010 042702 A1 ist die Ausbildung einer elektrisch leitenden Sinterverbindune aus Partikeln die einen Kern aus einer oranischen Metallverbindung und oder einem Metalloxid und einer Beschichtung, die ein Reduktionsmittel umfasst, bekannt. Bei Erwärmung der Partikel kommt es zu einer Reduktion der organischen Metallverbindung und oder des Edelmetalloxids.

Die aus dem Stand der Technik bekannten Vorgehensweisen weisen allesamt Nachteile auf. So eignen sich zwar Leiterbahnen aus gesinterten Metallpartikeln sehr gut zum Löten, allerdings vertragen viele Träger die zum Sintern erforderlichen Temperaturen nicht. Leiterbahnen aus ungesinterten Metallpartikeln, wie sie beispielsweise aus Niedertemperatur-Leitpasten gedruckt werden können, umfassen häufig einen organischen Binder, der sich durch ein flüssiges Lotmittel nur schlecht benetzen lässt. Stattdessen löst das Lotmittel Metallpartikel aus der Leiterbahn, in Extremfällen kann die Leiterbahn dabei Schaden nehmen.

Natürlich können gedruckte Leiterbahnen auch galvanisch verstärkt werden, bevor sie mit elektronischen Bauelementen verlötet werden. Ein solcher nasschemischer Zwischenschritt ist allerdings sehr aufwendig.

Der Erfindung lag die Aufgabe zugrunde, zur Lösung dieser Probleme ein verbessertes Verfahren zum Herstellen einer Lötverbindung bereitzustellen. Das Verfahren sollte einen rein additiven Auftrag der zur Bildung der Lötverbindung erforderlichen Schichten ermöglichen, insbesondere über Druckverfahren, und sich für eine Vielzahl von Trägern, auch temperaturempfindliche, eignen.

Zur Lösung dieser Aufgabe schlägt die Erfindung das Verfahren mit den Merkmalen des Anspruchs 1 vor. Weiterbildungen der Erfindung sind Gegenstand von Unteransprüchen.

Das erfindungsgemäße Verfahren zum Herstellen einer Lötverbindung zwischen einem Träger und einem Bauelement umfasst stets die vier unmittelbar folgenden Schritte a. bis d:
a. Auf eine Oberfläche des Trägers wird mittels eines Druckverfahrens eine Leiterschicht aufgedruckt, die Metallpartikel enthält.
b. Auf diese Leiterschicht wird mittels eines Druckverfahrens ein Lotmittel aufgedruckt.
c. Der Träger wird mit dem Bauelement bestückt.
d. Das Lotmittel wird aufgeschmolzen und erstarrt anschließend unter Ausbildung der Lötverbindung.
   Besonders zeichnet sich das Verfahren dadurch aus, dass
e. vor dem Aufdrucken des Lotmittels die Metallpartikel der Leiterschicht mit einem Edelmetallüberzug beschichtet werden und hierzu
f. auf die Leiterschicht mittels eines Druckverfahrens ein Lotvermittlungsmittel umfassend ein Edelmetallsalz oder ein Edelmetalloxid aufgedruckt wird, aus dem ein Edelmetall unter Bildung des Edelmetallüberzugs freigesetzt wird.

Überraschenderweise hat sich herausgestellt, dass durch den Einsatz des edelmetallsalzhaltigen Lotvermittlungsmittels stabile und zuverlässige Lötverbindungen erhalten werden können Dies gilt auch dann, wenn die Leiterschicht aus einer Niedertemperatur-Leitpaste gedruckt wird und die Metallpartikel nicht vor dem Aufschmelzen des Lotmittels in einem Zwischenschritt gesintert werden. Gemäß dem erfindungsgemäßen Verfahren lassen sich stabile Lötverbindungen zwischen Bauelementen und einem Träger bilden, ohne dass es nasschemischer Zwischenschritte bedarf. Der Auftrag der beteiligten Komponenten (Leiterschicht und Lotmittel) kann rein additiv erfolgen, insbesondere mittels Druck.

Als Druckverfahren eignet sich erfindungsgemäß insbesondere der Siebdruck. Dies gilt sowohl für das Aufdrucken der Leiterschicht als auch für das Aufdrucken des Lotvermittlungsmittels und des Lotmittels. Beim Siebdruck handelt es sich bekanntlich um ein Druckverfahren, bei dem Druckpasten bevorzugt mittels eines Rakels durch ein feinmaschiges Gewebe hindurch auf einen zu bedruckenden Träger gepresst werden. An denjenigen Stellen des Gewebes, an denen dem Druckbild entsprechend keine Paste aufgedruckt werden soll, werden die Maschenöffnungen des Gewebes undurchlässig gemacht. An den übrigen Stellen sollte die Druckpaste dagegen die Maschenöffnungen problemlos durchdringen können. Damit es nicht zu einem Verstopfen der Maschenöffnungen kommen kann, sollten in der Druckpaste enthaltene feste Bestandteile eine gewisse Maximalgröße, die unter der Maschenöffnungsweite liegen sollte, nicht überschreiten.

In bevorzugten Weiterbildungen der Erfindung zeichnet sich das in dem Verfahren eingesetzte Edelmetallsalz durch mindestens eines der unmittelbar folgenden Merkmale a. bis f. aus:
a. Das Edelmetallsalz ist ein Salz, das sich bei einer Temperatur ≤ 250 °C, bevorzugt ≤ 200 °C, zersetzt.
b. Das Edelmetallsalz ist ausgewählt aus der Gruppe mit Silbersalz, Kupfersalz, Goldsalz, Nickelsalz, Platinsalz und Palladiumsalz.
c. Das Edelmetallsalz ist ein Salz einer Carbonsäure, insbesondere ein Silbersalz einer Carbonsäure.
d. Die Carbonsäure ist eine C6- bis C15,-Carbonsäure, also eine Carbonsäure, die zwischen 6 und 15 Kohlenstoffatome umfasst.
e. Das mindestens eine Salz ist ein Neo-Decanoat.
f. Das mindestens eine Salz ist Silber-(I)-neo-decanoat.

Bevorzugt sind die unmittelbar vorstehenden Merkmale b. und c., besonders bevorzugt die unmittelbar vorstehenden Merkmale b. bis d., insbesondere die unmittelbar vorstehenden Merkmale a. bis d., in Kombination miteinander realisiert.

Ganz besonders bevorzugt ist das eingesetzte Edelmetallsalz ein Silbersalz einer Carbonsäure, insbesondere das erwähnte Silber-(I)-neo-decanoat.

Wenn das Lotvermittlungsmittel ein Edelmetalloxid umfasst, handelt es sich hierbei besonders bevorzugt um Silberoxid oder Kupferoxid.

Die Freisetzung des Edelmetalls aus dem Edelmetallsalz kann auf unterschiedliche Weisen initiiert werden. In weiteren bevorzugten Weiterbildungen der Erfindung zeichnet sich das beanspruchte Verfahren durch mindestens einen der unmittelbar folgenden Schritte a. bis c. aus:
a. Das Edelmetallsalz oder das Edelmetalloxid wird zur Freisetzung des Edelmetalls erwärmt, insbesondere auf eine Temperatur ≤ 250 °C, bevorzugt ≤ 200 °C.
b. Das Edelmetallsalz oder das Edelmetalloxid wird zur Freisetzung des Edelmetalls bestrahlt, insbesondere mit UV- oder Mikrowellenstrahlung.
c. Das Edelmetallsalz oder das Edelmetalloxid wird zur Freisetzung des Edelmetalls mit einem Reduktionsmittel in Kontakt gebracht.

Besonders bevorzugt umfasst das erfindungsgemäße Verfahren zur Freisetzung des Edelmetalls den Schritt a., wobei es bevorzugt sein kann, das Edelmetallsalz in Gegenwart eines Reduktionsmittels zu erwärmen. Die Metallpartikel der Leiterschicht werden also bevorzugt im Rahmen einer Wärmebehandlung mit dem Edelmetallüberzug beschichtet, bevor anschließend das Lotmittel auf die Leiterschicht aufgedruckt und aufgeschmolzen wird.

Die Erwärmung kann beispielsweise in einem Ofen erfolgen. Ggf. kann die Erwärmung in einer reduzierenden Atmosphäre erfolgen, beispielsweise in einer Wasserstoff- oder Kohlenmonoxid-Atmosphäre. Der Wasserstoff und das Kohlenmonoxid können dann als Reduktionsmittel wirken.

Es ist auch denkbar, die Erwärmung unter einem Schutzgas, beispielsweise unter Argon, durchzuführen.

Zur Freisetzung von Silber aus Silberoxid werden in der Regel immer ein Reduktionsmittel und eine Erwärmung benötigt.

In bevorzugten Ausführungsformen der Erfindung zeichnet sich das in dem Verfahren eingesetzte Lotvermittlungsmittel durch mindestens eines der unmittelbar folgenden Merkmale a. bis c. aus:
a. Das Lotvermittlungsmittel weist einen Silberanteil im Bereich von 10 bis 25 Gew.-% auf.
b. Das Lotvermittlungsmittel weist neben dem Edelmetallsalz ein Lösungsmittel auf.
c. Das Lotvermittlungsmittel weist neben dem Edelmetallsalz das Reduktionsmittel auf.

Bevorzugt sind zumindest die unmittelbar vorstehenden Merkmale b. und c. in Kombination miteinander realisiert.

Das Lösungsmittel wird insbesondere zugesetzt, um das Lotvermittlungsmittel in einen druckbaren Zustand zu überführen. Bei dem Lösungsmittel kann es sich beispielsweise um Wasser, einen Alkohol wie Isopropanol oder Ethylenglykol oder um eine alkoholische Lösung, beispielsweise ein Wasser/Ethylenglykol-Gemisch, handeln. Auch Aceton, Ethylacetat, Tetrahydrofuran oder Essigsäure können eingesetzt werden.

Als Reduktionsmittel können beispielsweise Ascorbinsäure, Zitronensäure, Glucose, Glycerinaldehyd oder Ammoniumformiat eingesetzt werden.

Weiterhin kann das Lotvermittlungsmittel als Zusatz einen Komplexbildner enthalten, der mit aus dem Edelmetallsalz oder dem Edelmetalloxid freigesetzten Edelmetallionen einen Komplex bilden kann. Ein Beispiel hierfür wäre Ammoniak.

In bevorzugten Ausführungsformen der Erfindung zeichnet sich das in dem Verfahren eingesetzte Lotmittel durch mindestens eines der unmittelbar folgenden Merkmale a. bis d. aus:
a. Das Lotmittel umfasst ein Niedertemperaturlot.
b. Das Lotmittel schmilzt bei einer Temperatur ≤ 250 °C, bevorzugt ≤ 200 °C.
c. Das Lotmittel umfasst eine Legierung umfassend die Elemente Sn, Bi und Ag.
d. Das Lotmittel wird als Paste oder Suspension verarbeitet.

Bevorzugt sind zumindest die unmittelbar vorstehenden Merkmale a. und b., besonders bevorzugt die unmittelbar vorstehenden Merkmale a., b. und d., insbesondere die unmittelbar vorstehenden Merkmale a. bis d., in Kombination miteinander realisiert.

Besonders bevorzugt erfolgt das Aufschmelzen des Lotmittels im Rahmen eines Reflow-Lötvorgangs.

Der Begriff Reflow-Löten oder Wiederaufschmelzlöten bezeichnet ein in der Elektrotechnik gängiges
Weichlötverfahren, bei dem das Lotmittel in Form einer Paste auf den zu verlötenden Leiter aufgebracht wird. Auf dieser Paste, die üblicherweise klebrig ist, können die zu verlötenden Bauteile fixiert
werden. Dann erst wird das Lotmittel aufgeschmolzen. Bei der nachfolgenden Abkühlung wird die Lötverbindung gebildet.

Als Träger können, wie eingangs erwähnt, auch vergleichsweise temperaturempfindliche Träger eingesetzt werden, also beispielsweise Träger aus Kunststoff. Bevorzugt weist der Träger mindestens eines der unmittelbar folgenden Merkmale a. bis c. auf:
a. Die Oberfläche des Trägers weist elektrisch isolierende Eigenschaften auf.
b. Die Oberfläche des Trägers besteht aus einem Kunststoff, einem keramischen Material oder einem Metalloxid.
c. Die Oberfläche des Trägers wird durch ein Druckverfahren gebildet.

Der Begriff "Kunststoff" schließt vorliegend insbesondere auch Lackschichten ein, beispielsweise Lackschichten auf Polyurethan- oder Epoxid-Basis. Dieses Lackschichten können auch Partikel aus dem keramischen Material oder dem Metalloxid enthalten.

In ganz besonders bevorzugten Ausführungsformen ist der Träger eine Aluminiumfolie, die eine Oberfläche aufweist, die von einer mittels Druck auf die Folie aufgebrachten elektrisch isolierenden
Schicht, beispielsweise aus keramischen Partikeln oder einer Lackschicht, gegebenenfalls mit den keramischen Partikeln, gebildet wird.

Der Träger weist bevorzugt eine maximale Länge von 1650 mm, insbesondere eine Länge im Bereich von 100 mm und 1650 mm, und eine maximale Breite von 1000 mm, insbesondere eine Breite im Bereich von 100 mm und 1000 mm, auf. Besonders bevorzugt ist er dabei rechteckig ausgebildet.

In bevorzugten Ausführungsformen der Erfindung zeichnet sich das in dem Verfahren eingesetzte Lotvermittlungsmittel durch mindestens eines der unmittelbar folgenden Merkmale a. bis c. aus:
Die gemäß dem Verfahren hergestellte Leiterschicht zeichnet sich bevorzugt durch mindestens eines der unmittelbar folgenden Merkmale a. bis e. aus:
a. Die Leiterschicht wird in Form einer Bahn auf den Träger aufgebracht.
b. Bei den Metallpartikeln handelt es sich um Partikel aus Silber, Kupfer, Gold, Palladium, Platin, Nickel oder einer Legierung dieser Metalle oder um eine Mischung solcher Partikel.
c. Die Schicht mit den Metallpartikeln wird aus einer Paste oder aus einer Suspension enthaltend die Metallpartikel gebildet.
d. Die Paste oder die Suspension weist neben den Metallpartikeln einen organischen Binder auf.
e. Die Schicht mit den Metallpartikeln wird durch ein Druckverfahren gebildet.

Besonders bevorzugt ist die Leiterschicht aus Silberpartikeln gebildet.

Das oben erwähnte Reduktionsmittel muss, in Fällen in denen es benötigt wird, nicht unbedingt Bestandteil des Lotvermittlungsmittels sein. Es ist zusätzlich oder alternativ auch möglich, das Reduktionsmittel bereits der Paste zuzusetzen, aus der die Leiterschicht gedruckt wird, oder es aber separat auf die Leiterschicht oder das Lotvermittlungsmittel aufzubringen, idealerweise wiederum durch ein Druckverfahren. Das Bauelement ist in aller Regel ein elektronisches Bauelement. In bevorzugten Ausführungsformen ist es ein oberflächenmontierbares Bauelement (englisch: Surfacemounted device, kurz SMD). In besonders bevorzugten Ausführungsform ist das Bauelement eine Leuchtdiode (kurz: LED).

Träger mit einem aufgelöteten Bauelement, das mit einer auf dem Träger angeordneten Leiterbahn über eine gemäß dem beschriebenen Verfahren hergestellte Lötverbindung verbunden ist, können sich dadurch auszeichnen, dass die Lötverbindung Spuren des in dem Verfahren verwendeten Edelmetallsalzes oder Edelmetalloxids umfasst.

Weiterhin offenbart sind Geräte mit einem Träger. Wenn das Bauelement eine LED ist, kann es sich bei dem Gerät beispielsweise um eine Leuchte handeln.

Weitere Merkmale der Erfindung sowie aus der Erfindung resultierende Vorteile ergeben sich aus dem nachfolgenden Ausführungsbeispiel und der Zeichnung, anhand derer die Erfindung erläutert wird.

Die nachfolgend beschriebene Ausführungsform dient lediglich zur Erläuterung und zum besseren Verständnis der Erfindung und ist in keiner Weise einschränkend zu verstehen.

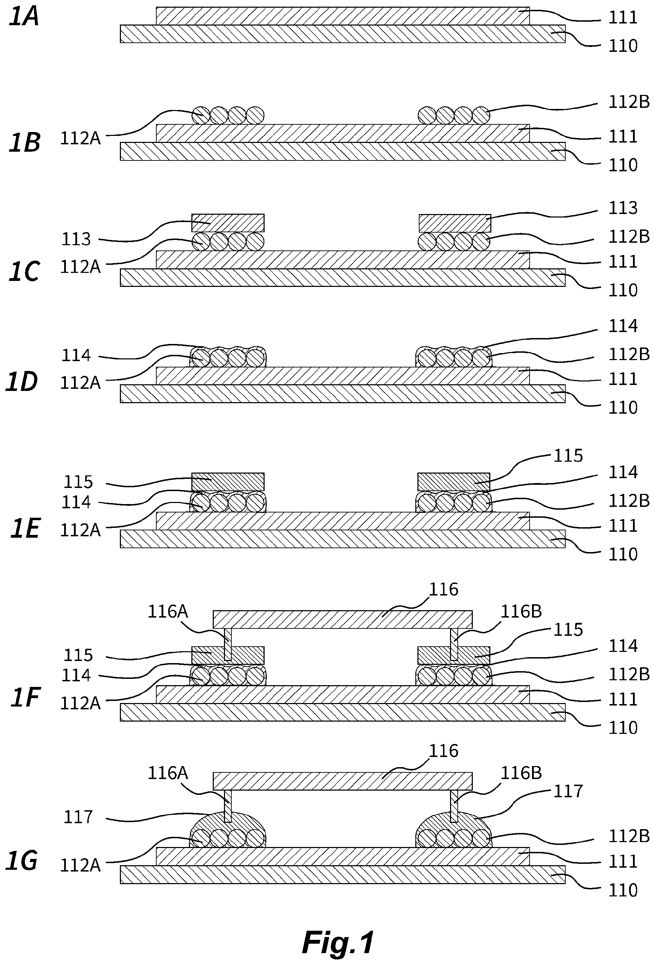

Fig. 1 illustriert schematisch den Ablauf des erfindungsgemäßen Verfahrens. In einem Schritt A wird auf eine als Träger dienende Aluminiumfolie 110 eine 50 µm dicke Isolierschicht 111 mit elektrisch isolierenden Eigenschaften gedruckt. Hierfür kann beispielsweise ein Lötstopplack verwendet werden, wie er von der Firma Lackwerke Peters GmbH & Co. KG mit Sitz in Kempen, Deutschland unter der Bezeichnung SD 2496 TSW vertrieben wird. Ein solcher Lötstopplack umfasst neben einem härtbaren Bindemittel meist auch einen partikulären keramischen Füllstoff.

Auf die Isolierschicht 111 werden in einem Schritt B die Silberpartikel umfassenden Leiterbahnen 112 (112A und 112B) gedruckt. Eine hierfür geeignete Paste wird beispielsweise von der Firma Creative Materials, Inc. mit Sitz in Ayer, MA 01432, USA unter der Bezeichnung 125-26A/B119-44 vertrieben. Diese umfasst neben Silberpartikeln mit einer Partikelgröße < 10 um in einem Anteil von mindestens 85 % ein 2K-Epoxysystem als Binder. Die jeweils vier die Leiterbahnen 112A und 112B bildenden Silberpartikel sind in Figur 1 nicht maßstabsgetreu dargestellt und auch die dargestellte Anzahl der Silberpartikel ist willkürlich gewählt.

Auf die Leiterbahnen 112A und 112B bzw. auf die Silberpartikel der Leiterbahnen wird in einem Schritt C bereichs- oder abschnittsweise ein pastöses Lotvermittlungsmittel 113 aufgedruckt, das Silber-(I)- neo-decanoat als Edelmetallsalz umfasst.

Unmittelbar danach wird in einem Schritt D die Aluminiumfolie 110 mitsamt der Isolierschicht 111, den Leiterbahnen 112A und 112B und dem pastösen Lotvermittlungsmittel 113 bei einer Temperatur von 200 °C über eine Zeitdauer von 3 bis 5 min in einem Ofen erwärmt. Dabei wird metallisches Silber aus dem Edelmetallsalz freigesetzt und scheidet sich auf der Oberfläche der in der Silberpaste enthaltenen Silberpartikel ab. Es bildet dort den Edelmetallüberzug 114.

In einem Schritt E wird dann ein Lot 115 auf den Edelmetallüberzug 114 gedruckt. Geeignet ist beispielsweise ein pastöses Niedertemperaturlot mit einem Schmelzpunkt < 140 °C, das Partikel der Zusammensetzung 42 % Sn, 57,6 % Bi und 0,4 % Ag in einem Anteil von 90% umfasst, wobei die Partikel Partikelgrößen im Bereich von 25 bis 45 um aufweisen. Ein solches Lot wird beispielsweise von der Firma Alpha Assembly Solutions mit Sitz in Woking, Surrey, GU21 5RW, United Kingdom unter der Bezeichnung ALPHA^{®} CVP-520 vertrieben.

In einem Schritt F wird ein elektronisches Bauelement 116 mit seinen elektrischen Kontakten 116A und 116 B an dem Niedertemperaturlot 115 fixiert. Bei dem elektronischen Bauelement kann es sich beispielsweise um eine LED handeln.

In einem Schritt G wird das Niedertemperaturlot115 aufgeschmolzen und erstarrt unter Bildung einer Lötverbindung 117 zwischen den Leiterbahnen 112 und dem elektronischen Bauelement 116.

## Patentansprüche

1. Verfahren zum Herstellen einer Lötverbindung (117) zwischen einem Träger (110) und einem Bauelement (116), bei dem
a. auf eine Oberfläche (111) des Trägers (110) mittels eines Druckverfahrens eine Leiterschicht (112A, 112B) aufgedruckt wird, die Metallpartikel enthält, und
b. auf diese Leiterschicht (112A, 112B) mittels eines Druckverfahrens ein Lotmittel (115) aufgedruckt wird, und
c. der Träger (110) mit dem Bauelement (116) bestückt wird, so dass das Bauelement (116) in unmittelbarem Kontakt mit dem Lotmittel (115) steht, und
d. das Lotmittel (115) aufgeschmolzen wird und anschließend unter Ausbildung der Lötverbindung (117) erstarrt,
**dadurch gekennzeichnet, dass**
e. vor dem Aufdrucken des Lotmittels (115) die Metallpartikel der Leiterschicht (112A, 112B) mit einem Edelmetallüberzug (114) beschichtet werden und hierzu
f. auf die Leiterschicht (112A, 112B) mittels eines Druckverfahrens ein Lotvermittlungsmittel (113) umfassend ein Edelmetallsalz oder ein Edelmetalloxid aufgedruckt wird, aus dem ein Edelmetall unter Bildung des Edelmetallüberzugs (114) freigesetzt wird.

2. Verfahren nach Anspruch 1 mit mindestens einem der folgenden zusätzlichen Merkmale:
a. Das Edelmetallsalz ist ein Salz, das sich bei einer Temperatur ≤ 250 °C, bevorzugt ≤ 200 °C, zersetzt.
b. Das Edelmetallsalz ist ausgewählt aus der Gruppe mit Silbersalz, Kupfersalz, Goldsalz, Nickelsalz, Platinsalz und Palladiumsalz.
c. Das Edelmetallsalz ist ein Salz einer Carbonsäure, insbesondere ein Silbersalz einer Carbonsäure.

3. Verfahren nach Anspruch 1 oder Anspruch 2 mit mindestens einem der folgenden zusätzlichen Merkmale:
a. Das Edelmetallsalz oder das Edelmetalloxid wird zur Freisetzung des Edelmetalls erwärmt, insbesondere auf eine Temperatur ≤ 250 °C, bevorzugt ≤ 200 °C.
b. Das Edelmetallsalz oder das Edelmetalloxid wird zur Freisetzung des Edelmetalls bestrahlt, insbesondere mit UV- oder Mikrowellenstrahlung.
c. Das Edelmetallsalz oder das Edelmetalloxid wird zur Freisetzung des Edelmetalls mit einem Reduktionsmittel in Kontakt gebracht.

4. Verfahren nach einem der vorhergehenden Ansprüche mit mindestens einem der folgenden zusätzlichen Merkmale:
a. Das Lotvermittlungsmittel (113) weist einen Silberanteil im Bereich von 10 bis 25 Gew.-% auf.
b. Das Lotvermittlungsmittel (113) weist neben dem Edelmetallsalz ein Lösungsmittel auf.
c. Das Lotvermittlungsmittel (113) weist neben dem Edelmetallsalz das Reduktionsmittel auf.

5. Verfahren nach einem der vorhergehenden Ansprüche mit mindestens einem der folgenden zusätzlichen Merkmale:
a. Das Lotmittel (115) umfasst ein Niedertemperaturlot.
b. Das Lotmittel (115) schmilzt bei einer Temperatur ≤ 250 °C, bevorzugt ≤ 200 °C.
c. Das Lotmittel (115) umfasst eine Legierung umfassend die Elemente Sn, Bi und Ag.
d. Das Lotmittel (115) wird als Paste oder Suspension verarbeitet.

6. Verfahren nach einem der vorhergehenden Ansprüche mit mindestens einem der folgenden zusätzlichen Merkmale:
a. Die Oberfläche (111) des Trägers (110) weist elektrisch isolierende Eigenschaften auf.
b. Die Oberfläche (111) des Trägers (110) besteht aus einem Kunststoff, einem keramischen Material oder einem Metalloxid.
c. Die Oberfläche (111) des Trägers (110) wird durch ein Druckverfahren gebildet.

7. Verfahren nach einem der vorhergehenden Ansprüche mit mindestens einem der folgenden zusätzlichen Merkmale:
a. Die Leiterschicht (112A, 112B) wird in Form einer Bahn auf den Träger (110) aufgebracht.
b. Bei den Metallpartikeln handelt es sich um Partikel aus Silber, Kupfer, Gold, Palladium, Platin, Nickel oder einer Legierung dieser Metalle oder um eine Mischung solcher Partikel.
c. Die Schicht (112A, 112B) mit den Metallpartikeln wird aus einer Paste oder aus einer Suspension enthaltend die Metallpartikel gebildet.
d. Die Schicht (112A, 112B) mit den Metallpartikeln wird durch ein Druckverfahren gebildet.

8. Verfahren nach einem der vorhergehenden Ansprüche mit mindestens einem der folgenden zusätzlichen Merkmale:
a. Das Bauelement (116) ist ein oberflächenmontierbares Bauelement.
b. Das Bauelement (116) ist eine LED.

9. Verfahren nach einem der vorhergehenden Ansprüche mit den folgenden zusätzlichen Merkmalen:
a. Das mindestens eine Salz ist ein Neo-Decanoat.
b. Das mindestens eine Salz ist ein Silbersalz.

10. Verfahren nach einem der vorhergehenden Ansprüche mit den folgenden zusätzlichen Merkmalen:
a. Das mindestens eine Salz ist Silber-(I)-neo-decanoat.

11. Verfahren nach einem der Ansprüche 2 bis 10 mit den folgenden zusätzlichen Merkmalen:
a. Die Carbonsäure ist eine C5-bis C15-Carbonsäure.

12. Verfahren nach einem der Ansprüche 7 bis 9 mit den folgenden zusätzlichen Merkmalen:
a. Die Paste oder die Suspension weist neben den Metallpartikeln einen organischen Binder auf.

## Claims

1. Method of making a solder joint (117) between a carrier (110) and a component (116), wherein
a. a conductive layer (112A, 112B) containing metal particles is printed onto a surface (111) of the carrier (110) by means of a printing process;
b. a soldering agent (115) is printed onto this conductive layer (112A, 112B) by means of a printing process;
c. the carrier (110) is equipped with the component (116) so that the component (116) is in direct contact with the soldering agent (115), and
d. the solder (115) is melted and subsequently solidifies to form the solder joint (117),
**characterized in that**
e. before the soldering agent (115) is printed on, the metal particles of the conductive layer (112A, 112B) are coated with a noble metal coating (114) and for this purpose
f. a soldering adjuvant (113) comprising a noble metal salt or a noble metal oxide is printed onto the conductive layer (112A, 112B) by means of a printing method, from which noble metal salt or noble metal oxide a noble metal is released to form the noble metal coating (114).

2. The method according to claim 1, having at least one of the following additional features:
a. The noble metal salt is a salt that decomposes at a temperature ≤ 250 °C, preferably ≤ 200 °C.
b. The noble metal salt is selected from the group consisting of silver salt, copper salt, gold salt, nickel salt, platinum salt, and palladium salt.
c. The noble metal salt is a salt of a carboxylic acid, in particular a silver salt of a carboxylic acid.

3. Method according to claim 1 or claim 2 with at least one of the following additional features:
a. The noble metal salt or the noble metal oxide is heated to release the noble metal, in particular to a temperature ≤ 250 °C, preferably ≤ 200 °C.
b. The noble metal salt or the noble metal oxide is irradiated to release the noble metal, in particular with UV or microwave radiation.
c. The noble metal salt or the noble metal oxide is contacted with a reducing agent to release the noble metal.

4. Method according to any one of the preceding claims, having at least one of the following additional features:
a. The soldering adjuvant (113) has a silver content in the range of 10 to 25 wt.%.
b. The soldering adjuvant (113) contains a solvent in addition to the noble metal salt.
c. The soldering adjuvant (113) contains the reducing agent in addition to the noble metal salt.

5. Method according to any one of the preceding claims, having at least one of the following additional features:
a. The solder agent (115) comprises a low temperature solder.
b. The solder agent (115) melts at a temperature≤250°C, preferably ≤ 200°C.
c. The solder agent (115) comprises an alloy comprising the elements Sn, Bi, and Ag.
d. The solder agent (115) is processed as a paste or suspension.

6. Method according to any one of the preceding claims, having at least one of the following additional features:
a. The surface (111) of the carrier (110) has electrically insulating properties.
b. The surface (111) of the carrier (110) is made of a plastic, a ceramic material or a metal oxide.
c. The surface (111) of the carrier (110) is formed by a printing process.

7. Method according to any one of the preceding claims, having at least one of the following additional features:
a. The conductive layer (112A, 112B) is applied on the carrier (110) in the form of a web.
b. The metal particles are particles of silver, copper, gold, palladium, platinum, nickel, or an alloy of these metals, or a mixture of such particles.
c. The layer (112A, 112B) containing the metal particles is formed from a paste or from a suspension containing the metal particles.
d. The layer (112A, 112B) with the metal particles is formed by a printing process.

8. Method according to any one of the preceding claims, having at least one of the following additional features:
a. The component (116) is a component which can be mounted to a surface.
b. The component (116) is an LED.

9. Method according to any one of the preceding claims, having the following additional features:
a. The at least one salt is a neo-decanoate.
b. The at least one salt is a silver salt.

10. Method according to any one of the preceding claims, having the following additional features:
a. The at least one salt is silver (I) neo-decanoate.

11. Method according to any one of claims 2 to 10, having the following additional features:
a. The carboxylic acid is a C5- to C15-carboxylic acid.

12. Method according to any one of claims 7 to 9, having the following additional features:
a. The paste or the suspension has, in addition to the metal particles, an organic binder.

## Revendications

1. Procédé, destiné à créer une liaison par brasage (117) entre un support (110) et un composant (116), lors duquel
a. au moyen d'un procédé d'impression, l'on imprime sur une surface (111) du support (110), une couche conductrice (112A, 112B) qui contient des particules métalliques, et
b. au moyen d'un procédé d'impression, l'on imprime sur ladite couche conductrice (112A, 112B) un métal d'apport de brasage (115), et
c. l'on équipe le support (110) avec le composant (116), de telle sorte que le composant (116) se trouve en contact direct avec le métal d'apport de brasage (115), et
d. l'on fait fondre le métal d'apport de brasage (115) pour ensuite le faire solidifier en créant la liaison par brasage (117),
**caractérisé**
e. **en ce qu'**avant l'impression du métal d'apport de brasage (115), l'on revêt les particules métalliques de la couche conductrice (112A, 112B) d'un revêtement (114) de métal noble et à cet effet,
f. au moyen d'un procédé d'impression, l'on imprime sur la couche conductrice (112A, 112B) un médiateur de brasage (113) comprenant un sel de métal noble ou un oxyde de métal noble à partir duquel se libère un métal noble en formant le revêtement (114) de métal noble.

2. Procédé selon la revendication 1 comportant au moins l'une des caractéristiques additionnelles suivantes :
a. le sel de métal noble est un sel qui se décompose à une température ≤ 250 °C, de préférence ≤ 200 °C.
b. Le sel de métal noble est sélectionné dans le groupe comprenant le sel d'argent, le sel de cuivre, le sel d'or, le sel de nickel, le sel de platine et le sel de palladium.
c. Le sel de métal noble est un sel d'un acide carboxylique, notamment un sel d'argent d'un acide carboxylique.

3. Procédé selon la revendication 1 ou la revendication 2, comportant au moins l'une des caractéristiques additionnelles suivantes:
a. pour libérer le métal noble, l'on fait chauffer le sel de métal noble ou l'oxyde de métal noble, notamment à une température ≤ 250 °C, de préférence ≤ 200 °C.
b. Pour libérer le métal noble, l'on irradie le sel de métal noble ou l'oxyde de métal noble, notamment au rayonnement UV ou micro-ondes.
c. Pour libérer le métal noble, l'on met le sel de métal noble ou l'oxyde de métal noble en contact avec un agent réducteur.

4. Procédé selon l'une quelconque des revendications précédentes, comportant au moins l'une des caractéristiques additionnelles suivantes:
a. le médiateur de brasage (113) comporte une teneur en argent de l'ordre de 10 à 25 % en poids.
b. en plus de le sel de métal noble, le médiateur de brasage (113) comporte un solvant.
c. en plus de le sel de métal noble, le médiateur de brasage (113) comporte l'agent réducteur.

5. Procédé selon l'une quelconque des revendications précédentes comportant au moins l'une des caractéristiques additionnelles suivantes:
a. le métal d'apport de brasage (115) comprend une brasure basse température.
b. Le métal d'apport de brasage (115) fond à une température ≤ 250 °C, de préférence ≤ 200 °C.
c. Le métal d'apport de brasage (115) comprend un alliage comprenant les éléments Sn, Bi et Ag.
d. Le métal d'apport de brasage (115) est mis en œuvre sous la forme d'une pâte ou d'une suspension.

6. Procédé selon l'une quelconque des revendications précédentes comportant au moins l'une des caractéristiques additionnelles suivantes:
a. la surface (111) du support (110) présente des propriétés d'isolant électrique.
b. La surface (111) du support (110) est constituée d'une matière plastique, d'une matière céramique ou d'un oxyde métallique.
c. L'on créé la surface (111) du support (110) par un procédé d'impression.

7. Procédé selon l'une quelconque des revendications précédentes comportant au moins l'une des caractéristiques additionnelles suivantes:
a. L'on applique la couche conductrice (112A, 112B) sur le support (110) sous la forme d'une bande.
b. Les particules métalliques sont des particules d'argent, de cuivre, d'or, de palladium, de platine, de nickel ou un alliage desdits métaux ou un mélange de telles particules.
c. L'on créé la couche (112A, 112B) avec les particules métalliques à partir d'une pâte ou d'une suspension contenant les particules métalliques.
d. L'on créé la couche (112A, 112B) avec les particules métalliques par un procédé d'impression.

8. Procédé selon l'une quelconque des revendications précédentes, comportant au moins l'une des caractéristiques additionnelles suivantes:
a. le composant (116) est un composant susceptible d'être monté sur une surface
b. Le composant (116) est une LED.

9. Procédé selon l'une quelconque des revendications précédentes, comportant les caractéristiques additionnelles suivantes:
a. l'au moins un sel est un néodécanoate.
b. L'au moins un sel est un sel d'argent.

10. Procédé selon l'une quelconque des revendications précédentes, comportant les caractéristiques additionnelles suivantes:
a. L'au moins un sel est un (I)-néodécanoate d'argent.

11. Procédé selon l'une quelconque des revendications 2 à 10, comportant les caractéristiques additionnelles suivantes:
a. l'acide carboxylique est un acide carboxylique en C5 à C15.

12. Procédé selon l'une quelconque des revendications 7 à 9, comportant les caractéristiques additionnelles suivantes:
a. en plus de les particules métalliques, la pâte ou la suspension comporte un liant organique.
